# EUROPEAN PATENT APPLICATION

(11) **EP 2 375 440 A2**
(43) Date of publication of application: **12.10.2011**
(21) Application number: 11161078.8
(22) Date of filing: 04.04.2011
(51) Int. Cl.: H01L 21/00, H01L 21/677

(54) **Automated material handling system with identification features**

(30) Priority: 06.04.2010 US 754922
(71) Applicant: Murata Machinery, Ltd., Minami-ku Kyoto-shi Kyoto 601-8326 (JP)
(72) Inventor: Sullivan, Robert P., Wilmington, MA 01887 (US); Mariano, Thomas R., Londonderry, NH 03053 (US); Haris, Clinton M., Lunenburg, MA 01462 (US); Pickreign, Richard J., Harvard, MA 01451 (US)
(74) Representative: Zimmermann, Tankred Klaus

(57) **Abstract**

Amongst other things, a material handling system comprises a controller; a transport system, the transport system comprising transport track sections and at least one transport vehicle, the at least one transport vehicle configured to move along the transport track sections and configured to transport a carrier; and at least one identification tag reader located along a particular transport track section, the at least one identification tag reader being configured to read an identification tag of the carrier being transported by the at least one transport vehicle and being further configured to send a information signal to the controller; wherein the controller is configured to verify at least a location of the carrier based on the information signal.

## Description

### BACKGROUND

### 1. Field

The exemplary embodiments relate to material handling systems and, more particularly, to automated material handling systems for transporting and identifying carriers in processing facilities.

### 2. Related Developments

Consumers continue to manifest a desire for ever more sophisticated electronic and electrical devices that are smaller in size and cheaper than current models. Manufacturers of microelectronic devices are thus under increased pressure to provide more capabilities to the devices while at the same time reducing the cost of the devices. The potential for reduction in cost of the materials used in fabricating the microelectronic devices, or in the cost related to actual fabrication of the devices is limited. However, significant cost reductions may be achieved by increasing the efficiency of the whole manufacturing process.

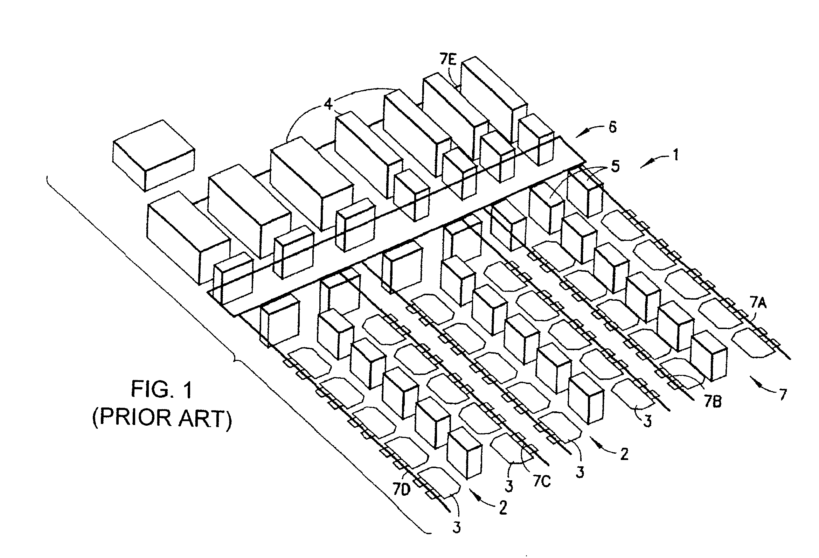

Automated Material Handling Systems (AMHS) have been installed in many fabrication facilities to increase manufacturing efficiency. Referring to Fig. 1, there is shown a perspective view of a representative conventional semiconductor fabrication facility 1. The fabrication or fab facility 1 has a number of fab bays 2 arranged in the facility in a desired array. The fab bays 2 include vacuum and atmospheric processing tools 3, 4 where the semiconductor devices are manufactured. The fab facility 1 also has an AMHS installed therein for transporting the semiconductor material to and from the semiconductor devices. The conventional material handling system in the fab facility shown in Fig. 1, generally includes stockers 5, interbay transport system 6, and intrabay transport system 7. In this arrangement, the stockers 5, used to store the semiconductor devices between various processing evolutions, are located adjacent the opening of the fab bays 2 on a common passage linking the fab bays 2. The interbay transport system 6 is installed in the common passage and connects the stockers 5. This allows semiconductor devices to be transported, by suitable vehicles traveling on the interbay transport system 6 between stockers 5. The intrabay transport system 7, as seen in Fig. 1, has sections 7A-7B disposed in the fab bays linking the stockers 5 adjacent the opening of a given bay to the processing tools 3, 4 in that bay. Thus, semiconductor devices can be transported between the stockers 5 of a bay and the processing tools in that bay with suitable vehicles traveling on the corresponding section 7A-7E of the intrabay transport system. The semiconductor devices may be substrates that are arranged in and organized into lots with each container holding one lot. For example, the containers may be FOUPs holding lots of 25 substrates. Each FOUP may be provided with an identification tag for identifying a lot number for the lot of substrates contained in the FOUP. The identification tag could be a bar code tag, radio frequency identification (RFID) tag, or other type of identification tag. The identification tags may be read at only certain points within the fab. For example, identification tags may be read at input ports of the stockers 5, for example when a human operator is loading a container into the AMHS system. Also, the process tools are sometimes configured to read identification tags. When the AMHS obtains a container from a process tool, a process tool control system may communicate with an AMHS control system to indicate to the AMHS the identity of the container (or of the lot held in the container) that is being obtained, after the identification tag has been read by the process tool.

AMHS as described above may lack an ability to verify the identity of a lot when the lot is within the domain of the AMHS. As described above, the identification tag may only be read when the container is introduced into the system by a human operator, or when the container is introduced into the domain of the AMHS from a process tool. However, errors may occur such that the AMHS control system may register the container with an incorrect lot number. For example, a process tool may be offline when a container is loaded or the identification tag reader at the process tool may be disabled when containers are switched at the process tool. Additionally, some process tools may not have tag readers and may rely instead on a human operator typing a lot number on a keypad, which can easily result in a mistyped identifier. If a mistake is made, a container may be introduced to the AMHS with the wrong identification number, and the lot may become lost within the system. When this happens, the efficiency of the fabrication facility may certainly be effected. It may sometimes even be necessary to conduct a manual search to find a lost lot. It may therefore be desired to provide an AMHS system with verification features to ensure that a lot has not been misidentified. It may further be desired to provide an AMHS that can efficiently locate misidentified lots.

### SUMMARY

The present disclosure provides a material handling system comprising:
a controller; a transport system, the transport system comprising transport track sections and at least one transport vehicle, the at least one transport vehicle configured to move along the transport track sections and configured to transport a carrier; and at least one identification tag reader located along a particular transport track section, the at least one identification tag reader being configured to read an identification tag of the carrier being transported by the at least one transport vehicle and being further configured to send a information signal to the controller; wherein the controller is configured to verify at least a location of the carrier based on the information signal.

Implementations of the disclosure may include one or more of the following features. In some implementations, the transport track sections comprise turntables joining different transport track sections and the at least one identification tag reader is located substantially in or on the turntables. In some implementations, the at least one identification tag reader is located substantially at an end of the particular transport track section and the at least one identification tag reader is configured to read the identification tag as the carrier is being transported from a substrate processing station.

In some implementations, the material handling system comprises an automated overhead material handling system and the controller is configured to effect a recovery of a mislocated carrier when a detected position of the mislocated carrier does not match a predetermined position. In some implementations, the identification tag comprises a radio frequency identification tag.

Another aspect of the disclosure provides a material handling system comprising: a controller; a transport system, the transport system comprising transport track sections and at least one transport vehicle, the at least one transport vehicle being configured to move along the transport track sections and configured to transport a carrier; and an identification tag reader in communication with the controller and being configured to traverse the transport track sections as a unit with the at least one transport vehicle, wherein the identification tag reader is configured to read an identification tag of the carrier being transported by the at least one transport vehicle and to send a information signal to the controller; wherein the controller is configured to verify at least a location of the carrier based on the information signal.

Implementations of the disclosure may include one or more of the following features. In some implementations, the identification tag reader is located substantially in or on a particular transport vehicle and the identification tag reader is configured to read the identification tag as a respective carrier is being transported from a substrate processing station. In some implementations, the material handling system comprises an automated overhead material handling system and the controller is configured to effect a recovery of a mislocated carrier when a detected position of the mislocated carrier does not match a predetermined position.

Another aspect of the disclosure provides a method of verifying a location of a carrier payload in a material handling system, the method comprising: transporting a carrier on a transport vehicle of the material handling system; reading an identification tag of the carrier being transported by the transport vehicle; and verifying a payload of the carrier is at a predetermined position, wherein the verifying is based on reading the identification tag.

Implementations of the disclosure may include one or more of the following features. In some implementations, an identification tag reader for reading the identification tag is located along a track segment of the material handling system and an identification tag reader for reading the identification tag is located substantially in or on a turntable connecting different sections of track of the material handling system. In some implementations, an identification tag reader for reading the identification tag is configured to traverse a track of the material handling system with the transport vehicle and the identification tag of the carrier is configured to be read in a track segment of the material handling system.

In some implementations, the identification tag is configured to be read as a carrier is being transported from a substrate processing station. In some implementations, the method further comprises recovering a mislocated payload when a detected position of the mislocated payload does not match a predetermined position.

### BRIEF DESCRIPTION OF THE DRAWINGS

The foregoing aspects and other features of the exemplary embodiments are explained in the following description, taken in connection with the accompanying drawings, wherein:

Fig. 1 is a schematic perspective view of a semiconductor fabrication facility with a conventional material handling system;

Fig. 2 and 3 are schematic plan views of transport systems in accordance with exemplary embodiments;

Fig. 4 is a schematic diagram of a part of a material handling system of Figure 3 in accordance with an exemplary embodiment;

Fig. 5 is a schematic plan view of material storage in a material handling system in accordance with an exemplary embodiment;

Fig. 6 is another schematic plan view of material storage in a material handling system in accordance with an exemplary embodiment;

Fig. 7 is a schematic view of a production tracking system in accordance with an exemplary embodiment;

Fig. 8 is a flow diagram of a method in accordance with an exemplary embodiment;

Fig. 9 is a schematic view of another production tracking system in accordance with an exemplary embodiment;

Fig. 9A is a schematic illustration of a transport vehicle in accordance with an exemplary embodiment;

Fig. 10 is a flow diagram of a method in accordance with an exemplary embodiment;

Fig. 11 is a schematic view of still another production tracking system in accordance with an exemplary embodiment; and

Fig. 12 is a flow diagram of a method in accordance with an exemplary embodiment.

### DETAILED DESCRIPTION

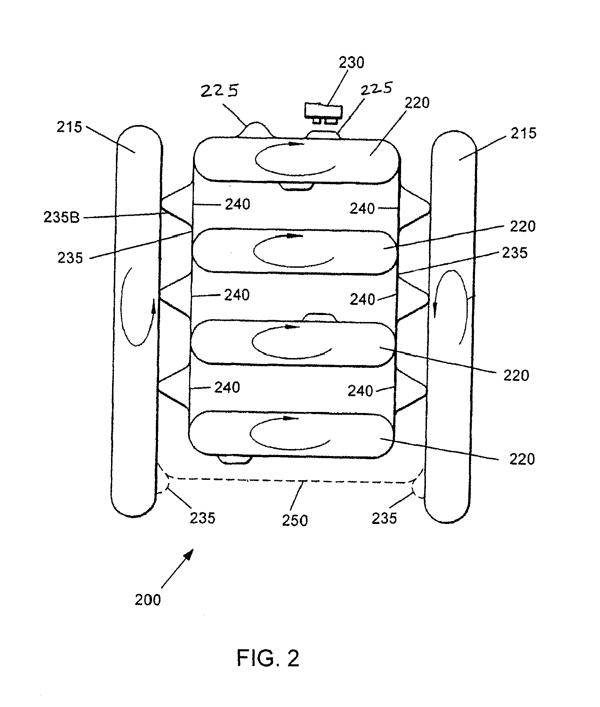

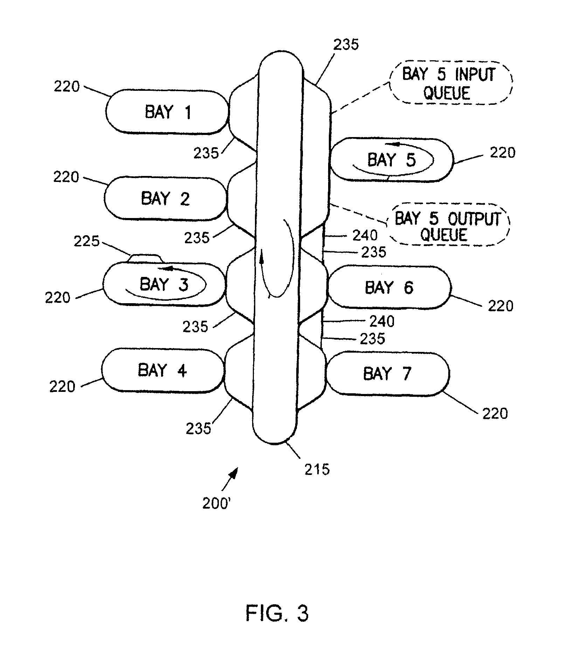

Referring to Figures 2 and 3, there is shown a schematic plan view of an automated material handling system 200, 200'. Although the embodiments disclosed will be described with reference to the embodiments shown in the drawings, it should be understood that the embodiments disclosed can be embodied in many alternate forms of embodiments. In addition, any suitable size, shape or type of elements or materials could be used.

The exemplary embodiments described herein provide for payload identification in an Automated Material Handling System (AMHS). For example, in one exemplary embodiment suitable identification readers can be located at various points throughout the AMHS such that the readers identify, for example suitable identification features of a substrate carrier as the carrier is transported past the reader or vice versa. In other exemplary embodiments the readers of the AMHS may be mobile. For example, the identification reader may be located in or along one or more of the substrate carriers, transport vehicles, transport tracks and turntables joining the transport tracks as will be described in greater detail below. In alternate embodiments the identification reader may be located in any suitable location for obtaining the identification information from the identification tag. In one exemplary embodiment the tags may be radio frequency identification (RFID) tags. In alternate embodiments, however, the tags may be any suitable tags or indicia capable of transmitting or allowing the reading of identification information or storing identification information for retrieval by a reader.

Although the exemplary embodiments are described herein with reference to semiconductor processing for exemplary purposes only, it should be understood that the exemplary embodiments are equally applicable for the transport of any suitable items over any suitable material handling system. It is also noted that the exemplary AMHS described herein may include an overhead hoist transport system for transporting substrate carriers but that the exemplary embodiments are equally applicable to any suitable transport system including, but not limited to, for example, manually guided vehicles and automated wheeled vehicles. One example of a suitable overhead hoist transport system is the Aeroloader series of transports from Brooks Automation, Inc. Other examples of suitable overhead transports are described in United States Patent numbers 7,117,800 and 7,040,238 both of which are incorporated by reference herein in their entirety.

Still referring to Figures 2 and 3, the exemplary AMHS 200, 200' generally includes an intrabay transport system section 215, an interbay transport system section 240, processing bay sections 220, bay queue sections 235, transport sidings or shunt sections 225 and workpiece carriers or transports. The AMHS may be substantially similar to that described in United States Patent Application entitled "Reduced Capacity Carrier, Transport, Load Port, Buffer System," having serial number 11/556,584, filed on November 3, 2006, which is incorporated herein by reference in its entirety. In alternate embodiments the AMHS may be any suitable material handling system.

The transport system sections 215, 220, 225, 235 may be nested together (i.e. one transport loop within another transport loop) and are generally arranged to allow the high-speed transfer of, for example semiconductor workpieces, such as for example, 200 mm wafer, 300 mm wafers, 450 mm wafers, flat display panels and similar such items, to and from processing bays 220 and associated processing tools 230 in the processing facility. In alternate embodiments, any suitable material may be conveyed in the automated material handling system. The transport system 200 may also allow for the redirection of workpieces from one transport section to any another transport section. An example of an automated material handling system for transporting workpieces having interbay and intrabay branches can be found in United States Patent Application entitled "Automated Material Handling System" having serial number 10/697,528, filed on October 30, 2003 which is incorporated herein by reference in its entirety.

The representative configurations of the automated material handling system 200, 200' shown in Figures 2 and 3 are for exemplary purposes only, and the automated material handling system 200, 200' may be disposed in any suitable configuration to accommodate any desired layout of processing bays and/or processing tools in a processing facility. As can be seen in Figure 2, the intrabay transport sections 215 may be located on either side of and connected to each other by any number of processing bays 220. The intrabay transport sections 215 of Figure 2 may also be connected by a cross-shunt 250 that allows the movement of a workpiece transport directly between intrabay transport sections 215 without passing through a processing or fabrication ("fab") bay 220. In yet other alternate embodiments, the transport sections 215 may be connected to each other by additional intrabay transport sections (not shown). In other alternate embodiments, as shown in Figure 3, the intrabay transport section 215 may be located between any number of processing bays 220 thereby forming a center isle between the bays 220. In other alternate embodiments, the intrabay transport section may form a perimeter around and enclose any number of processing bays 220. In yet other alternate embodiments, there may be any number of nested loop sections such as for example N number of systems, such as system 200 or 200' as shown in Figures 2 and 3, connected in parallel by transport sections that directly connect each of the intrabay transport sections 215. In still other alternate embodiments, the transport sections 215, 220 and processing tools may have any suitable configuration. In addition, any number of intrabay/interbay systems may be joined together in any suitable configuration to form nested processing arrays.

The intrabay transport section 215, may be a modular track system that provides for the movement of any suitable workpiece transport. Each module of the track system may be provided with a suitable mating means (e.g. interlocking facets, mechanical fasteners) allowing the modules to be joined together end to end during installation of the intrabay transport sections 215. The rail modules may be provided in any suitable length, such as a few feet, or in any suitable shape, such as straight or curved, for ease of handling during installation and configuration flexibility. The track system may support the workpiece transport from beneath or in alternate embodiments, the track system may be a suspended track system. The track system may have roller bearings or any other suitable bearing surface so that the workpiece transports can move along the tracks without substantial resistance over the rollers. The roller bearing may be tapered or the tracks may be angled towards the inside of a curve or corner in the track to provide additional directional stability when the workpiece container is moving along the track.

The intrabay transport sections 215 may be any suitable transport sections including, but not limited to, a conveyor based transport system, a cable and pulley or chain and sprocket based transport system, a wheel driven system or a magnetic induction based transport system. The motor used to drive the transport system may be any suitable linear motor with an unlimited stroke capable of moving workpiece containers along the intrabay transport sections 215. The linear motor may be a solid state motor without moving parts. For example, the linear motor may be a brushed or brushless AC or DC motor, a linear induction motor, or a linear stepper motor. The linear motor may be incorporated into the intrabay transport sections 215 or into workpiece transports or containers themselves. In alternate embodiments, any suitable drive means may be incorporated to drive the workpiece transports through the intrabay transport system. In yet other alternate embodiments, the intrabay transport system may be a pathway for trackless wheeled autonomous transport vehicles.

The intrabay transport sections 215 may generally allow for uninterrupted high-speed movement or flow of the workpiece transports along the path of the intrabay transport sections 215 through the use of queue sections and shunts as described in United States Patent Application No. 11/556,584. For example, the interbay transport sections 220 may form processing or fab bays and are connected to the intrabay transport sections 215 through bay queue sections 235. The bay queue sections 235 may be located on either side of the interbay or intrabay transport sections 220, 215 and allow a workpiece container to enter the interbay transport sections 220 without stopping or slowing down the flow of material along either the intrabay transport sections 215 or the flow of material along the interbay transport sections 220. An example of a transportation system having a travel lane and an access lane allowing selectable access on and off the travel lane can be found in United States Patent Application entitled "Transportation System" with serial number 11/211,236, filed on August 24, 2005, which is incorporated herein by reference in its entirety. The interbay transport sections 220 and the bay queue sections 235 may have track systems that are substantially similar to that described above for the intrabay transport sections 215. In alternate embodiments, the interbay transport sections 220 and the bay queue sections 235 may have any suitable configuration, shape or form and may be driven in any suitable manner.

The interbay transport sections 220 may extend within corridors or passages connecting any number of process tools 230 to the transport system 200, 200'. The interbay transport sections 220 may also connect two or more intrabay transport sections 215 to each other as shown in Figure 2 and as described above. The interbay transport sections 220 are shown in Figures 2 and 3 as having an elliptical shape however, in alternate embodiments they may have any suitable configuration or shape and may be adaptable to any fabrication facility layout. The interbay transport sections 220 may be connected to the process tools 230 through, for example, a transport siding or shunt 225, which may be substantially similar to the bay queue section 235. While in the shunt 225, the workpiece container may stop at a tool interface station (not shown) that corresponds to the location of the process tool station, so that the workpieces and/or the container itself may be transferred into the process tool load port or any other suitable workpiece staging area by or through any suitable transfer means, such as for example, an equipment front end module, sorter or any other suitable transfer robot. As will be described below, in one exemplary embodiment, the AMHS may also include a identification readers for determining a content of the carrier(s) as each carrier enters or exits the interbay or intrabay track segments.

The switching of the workpiece carriers or transports from and between the different sections 215, 220, 225, 235 may be controlled by any suitable guidance or material control system connected to a controller. The guidance system may include positioning devices allowing for position determination of the transports moving along the sections 215, 220, 225, 235, 240. The positioning devices may be of any suitable type such as continuous or distributed devices, such as optical, magnetic, bar code or fiducial strips, that extend along and across the sections 215, 220, 225, 235, 240. The distributed devices may be read or otherwise interrogated by a suitable reading device located on the transport to allow the controller to establish the position of the transport on the section 215, 220, 225, 235, 240 as well as the kinematic state of the transport. Alternatively, the devices may sense and/or interrogate a sensory item on the transport to identify position/kinematics. The positioning devices may also include, alone or in combination with the distributed devices, discrete positioning devices (e.g. laser ranging device, ultrasonic ranging device, or internal positioning system akin to internal GPS, or internal reverse GPS) able to sense the position of the moving transport. The controller may combine information from the guidance system with the position feed back information from the transport to establish and maintain the transport paths of the transport along and between the sections 215, 220, 225, 235, 240.

In alternate embodiments, guidance system may include or have grooves, rails, tracks or any other suitable structure forming structural or mechanical guide surfaces to cooperate with mechanical guidance features on the workpiece transports. In still other alternate embodiments, the sections 215, 220, 225, 235, 240 may also include electrical lines, such as a printed strip or conductor providing electronic guidance for the workpiece transports (e.g. electrical lines sending a suitable electromagnetic signal that is detected by a suitable guidance system on the transports). The identification reader(s) described herein may be connected to the guidance system in any suitable manner for redirecting or otherwise processing misidentified or mislocated substrate carriers through the AMHS as will be described below. In alternate embodiments, the misidentified or mislocated substrate carriers may be redirected or otherwise processed in any suitable manner.

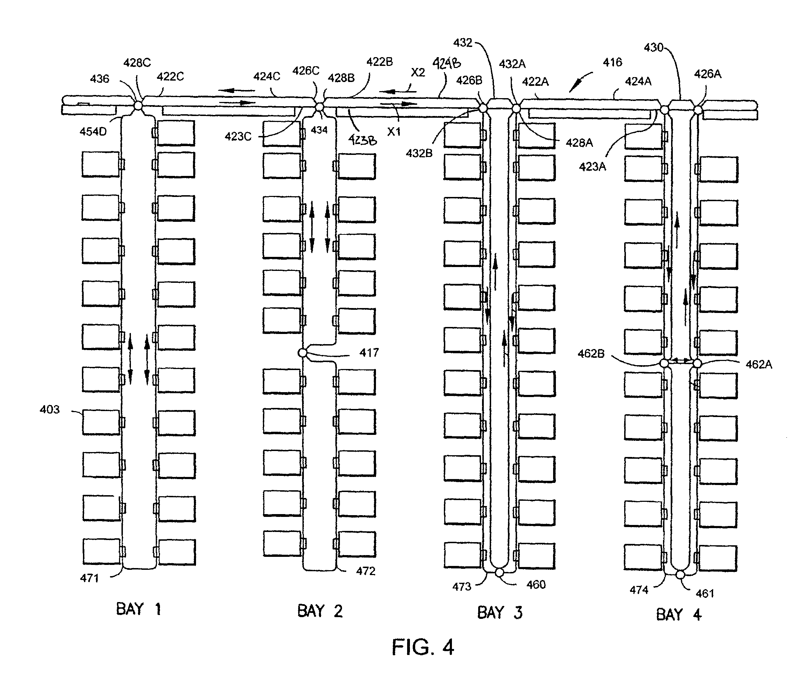

The AMHS may also be configured to have multiple transport paths in each of the transport segments as described in United States Patent No. 6,990,721, which is incorporated herein by reference in its entirety. As will be described in greater detail below, an identification reader may be located at the beginning and/or end of each transport path to identify the contents of, for example, a substrate carrier as it enters or exits a processing bay. In one example, referring now to Figure 4, each intrabay transport segment 422A-422C may have multiple transport paths 423A-424A, 423B-424B, 423C-424C provided by any suitable table means for transport vehicles (not shown), allowing the vehicles to traverse the segment. The transport vehicles may be any suitable transport vehicles such as for example the transport vehicles described in United States Patent Application No. 10/697,528. The transport paths of each segment may be arranged to allow substantially simultaneous bi-directional travel of the transport vehicles on the segment (in directions indicated by arrows X1, X2). As can be seen in Figure 4, one path, such as for example 423A, 423B, 423C, may be used by transport vehicles to travel in one direction (indicated by arrow X1) and the other path, 424A, 424B, 424C, may be used for travel in the opposite direction (indicated by arrow X2). The travel paths may be dedicated to a given direction of travel or the direction of travel may be switched as desired according to a transport algorithm to suit transport loading conditions. For example, in the non-dedicated case transport path 423A of segment 422A may at first be used for vehicles traveling in the direction indicated by arrow X1 in Figure 4. At that time, path 424A provides for travel in direction X2. However, if at some later time it is anticipated that some number of transport vehicles are situated in the facility and are going to a location where it would be more efficient to move over path 423A in direction X2, then the travel direction for path 423A may be changed to direction X2, path 424A now becoming used for X1 travel. Identification readers, as described below may be located at the beginning and end of each track segment to accommodate the bi-directional nature of the AMHS. In alternate embodiments the identification readers may be located at any suitable location with respect to the bi-directional transport paths.

As seen in Fig. 4, each segment 422A-422C may have a junction or turn table 430, 432, 434, 436 at corresponding opposite ends of the segment. For example, in the embodiment shown in Fig. 4 segment 422A has a junction 430 at one end 426A and another junction 432 at the opposite end 428A. Segments 422B, 422C are similar with respective junctions 432, 434, 436 at corresponding opposite ends 426B-426C, and 428B-428C of the segments. The respective travel paths 423A-423C, 424A-424C of each segment 422A-422C substantially intersect at each corresponding junction 430, 432, 434, 436 such that transport vehicles can pass from one segment to another segment. For example, the junctions 430, 432, 434, 436 may allow transport vehicles to pass from intrabay sections 422A-422C to interbay sections 471-474 for transporting carriers to processing tools 403. As can be seen in Figure 4, one or more of the interbay sections 471-474 may also include junctions or turntables 417, 460, 461, 462A, 462B as well as bi-directional tracks as described in United States Patent No. 6,990,721. As will be described in greater detail below, in one exemplary embodiment, one or more of the junctions or turntables may include identification readers for tracking a content of the carriers.

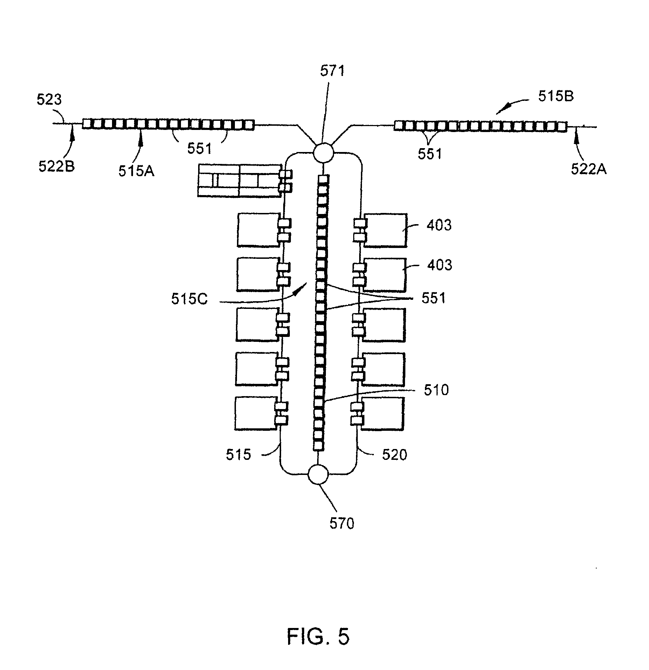

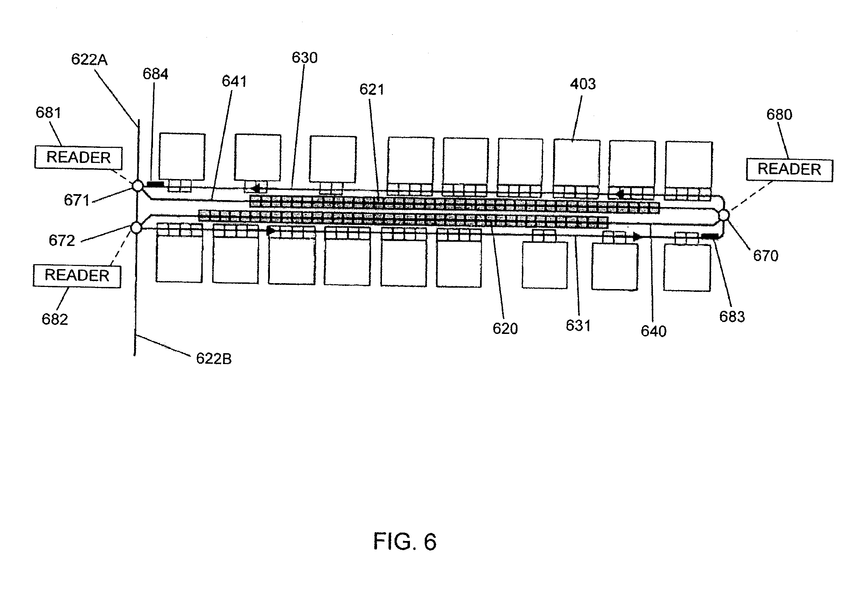

Referring now to Figures 5 and 6, a section of an AMHS incorporating features of an exemplary embodiment is shown. In this exemplary embodiment, the AMHS may include storage areas 515A, 515B, 515C, 620, 621 that are mounted to be suspended under a respective intrabay or interbay transport segment 515, 520, 522B, 522A, 510, 640, 641. As described above with respect to Fig. 4, the AMHS of Figure 5 may include turntables 570, 571 joining one or more of the transport segments 515, 520, 522B, 522A, 510, 640, 641. As will be described in greater detail below a mobile identification reader may be configured to pass along the storage areas to identify the content of, for example, each of the substrate carriers stored in the storage area. In one example, in the exemplary embodiment shown in Figure 5, the storage section 515A has material storage compartments 551 located under the transport path 523 of the transport segment 522B. In one exemplary embodiment, the material storage compartments may be configured to hold substrate carriers or containers such as for example, Front Opening Unified Pods (FOUPS) or any other suitable substrate carrier/container. In alternate embodiments, the material storage compartments may be configured to hold any suitable materials or substrates whether they are in a carrier or not. In other alternate embodiments the material storage compartments may be configured such that the compartments can be removed from the under track storage areas by the AMHS. As may be realized, an under-track storage system may be advantageous in that it can provide storage capacity to hold Work In Process (WIP) lots and thus serve as buffers for the process tools, but may not occupy any floor space of the facility as may otherwise be occupied by a stocker. As may also be realized, any suitable portion of the AMHS track may have under track storage as described in, for example, United States Patent No. 6,990,721.

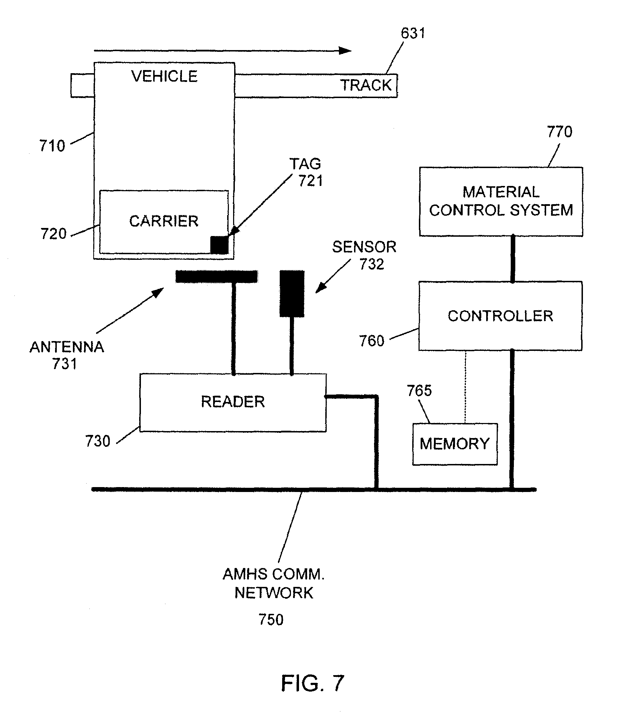

Referring still to Figure 6 and also to Figure 7 one exemplary embodiment of an AMHS with an identification/tracking system will now be described. The AMHS includes vehicle track(s) 631, transport vehicle 710, carrier(s) 720, identification readers 730, and a controller 760. It is noted that the AMS may be a unified AMHS or a segregated AMHS. The AMHS track(s) 631 may be substantially similar to those described above with respect to, for example, Figures 4-6. In alternate embodiments, the AMHS tracks may be any suitable tracks. The controller 760 may be any suitable controller configured for the operation of the AMHS. The controller 760 may include, for example, a memory 765 and any suitable software or hardware for operating the AMHS, such as material control system 770. The controller may be suitably connected to, for example, the transport vehicle(s) 710 and the identification reader(s) 730 through any suitable connections such as an AMHS communication network 750. The AMHS communication network 750 may be any suitable wired or wireless network including, but not limited to, an Ethernet local area network (LAN), a wide area network (WAN), a cellular network, a radio frequency network or any other suitable short or long range communication network.

As noted above, the transport container(s) 720 may be any suitable transport containers for carrying any suitable payload including, but not limited to, front opening unified pods (FOUPS) and standard mechanical interface (SMIF) pods. In this exemplary embodiment, each of the transport containers 720 of the AMHS may be equipped with, for example, a RFID tag 721. The RFID tag may be suitably located in or on any area of the carrier that allows for the reading of the tag by, for example, a RFID reader 730. As may be realized, in alternate embodiments any suitable identification techniques may be utilized in lieu of RFID including, but not limited to, one-dimensional or multi-dimensional bar codes, infrared tags, optical character recognition (OCR) of human-readable markings, or any other suitable techniques.

The RFID tag 721 may be any suitable RFID tag including, but not limited to, passive tags, active tags or semi-passive tags. In alternate embodiments the RFID tags may be substantially similar to GPS enabled tags that can be tracked by a fabrication facility positioning system (similar to the GPS system but able to track items within the fabrication facility) where the positioning system includes readers for reading an identification of the GPS enabled tags. The RFID tag 721 may be associated with the payload or contents of a respective carrier 720 when, for example the carrier is placed into the production stream as WIP. In alternate embodiments the contents of the carrier may be associated with a respective RFID tag at any suitable point in time. The association between the RFID tags and the carrier may be made manually by, for example an operator, or automatically such as by, for example, sensors reading the RFID tag identifier and indicia on one or more content of the carrier. In alternate embodiments, the association between the RFID tag and carrier contents may be established in any suitable manner. A description of the contents and the tag identifier may be sent to, for example, the material control system 770 of the controller 760 for inclusion in an identification database. The identification database may be stored in, for example, a memory 765 of a controller, such as controller 760. In alternate embodiments the identification database may be stored in a remote location that can be remotely accessed by the controller 760 and/or the material control system 770. In alternate embodiments the content description and associated tag identifier may be sent to any suitable location for recordation. Where, for example, the carrier(s) includes semiconductor substrates, the identification database may include any suitable information such as substrate size, number of substrate in the carrier and what processing stages the substrate(s) have undergone. As may be realized, the database may be configured to include any suitable information for any suitable materials being transported in the AMHS. In one exemplary embodiment, the database may be automatically updated, for example, with respect to the production status of the content of a carrier 720 as the carrier 720 passes an RFID reader as will be described in greater detail below. In alternate embodiments, any suitable information in the database may be updated in any suitable manner.

As described above and as can be seen in Figures 6 and 7, the RFID reader 680, 681, 682, 683, 684 may be located along a track or at a turntable of the AMHS. The RFID readers 680, 681, 682, 683, 684 may be any suitable readers configured to capture tag information as the tag is passed by the reader or vice versa. For example, the readers 680, 681, 682, 683, 684 may be substantially similar to RFID reader 730. The RFID reader 730 may include any suitable antenna 731 for receiving information from the RFID tag 721 and a sensor 732 for detecting the presence of the transport vehicle 710, RFID tag 721 and/or carrier 720. In one embodiment the sensor 732 may be any suitable sensor including, but not limited to, motion sensors, proximity sensors and optical sensors. In alternate embodiments the reader may include any suitable hardware and/or software for gathering information from the RFID tag and sensing the presence of an object including the RFID tag or the RFID tag itself. In still other alternate embodiments, the reader may be an optical reader or any other suitable reader for gathering information from any suitable identifying tag, marking or indicia.

As can be seen in Figure 6, RFID readers 680-684 may be placed at any suitable locations in the AMHS. In this exemplary embodiment, the RFID readers 680-684 may be located along the AMHS track, such as along track segments 630 and 631. In one exemplary embodiment the readers 680-684 may be located below the track segments but in alternate embodiments the readers may have any suitable positional relationship with the track segments. In this example, the RFID readers 683, 684 are located at the end of each track segment so that identification information is gathered from each carrier 720 as the carrier leaves a respective track segment 630, 631 or a respective processing tool 403. In other exemplary embodiments, RFID readers 680-682 may also be located at the beginning and/or in/on the turntables 670-672 that connect the different AMHS tracks so that the identification information may be gathered as the carriers enter/leave the respective tracks. In alternate embodiments the readers may be located in any suitable areas of the track segments including, but not limited to, the beginning of the track segments.

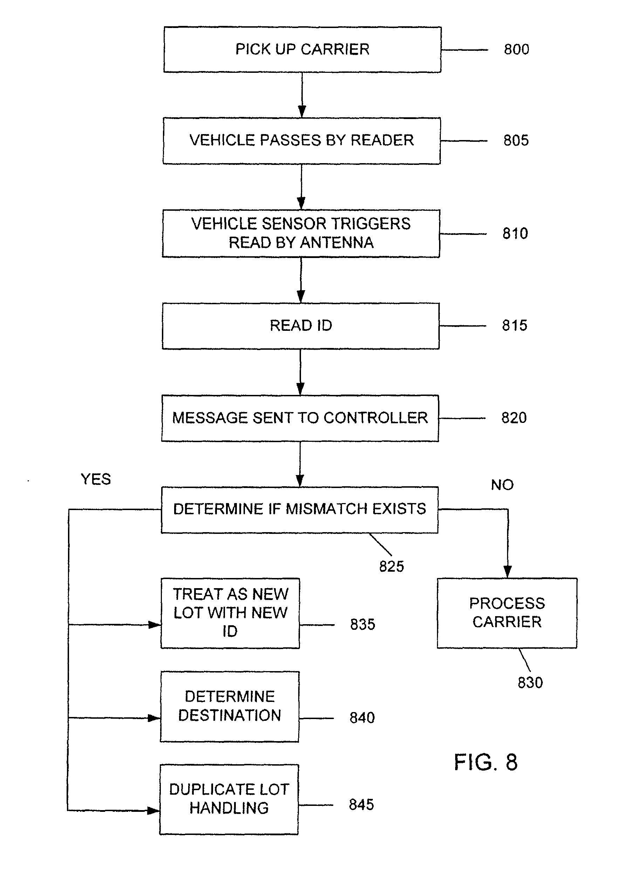

Referring also to Figure 8, an exemplary operation of the AMHS with the identification readers described herein will be described in accordance with the exemplary embodiment. In this exemplary embodiment, a transport vehicle such as vehicle 710 may pick a carrier 720 from one of the processing stations 403 (Fig. 8, Block 800). The vehicle 710 may transport the carrier 720 along, for example track segment 630 past an identification reader such as, for example, reader 684 (Fig. 8, Block 805). As the vehicle 710 passes the reader 684, vehicle sensor 732 detects the vehicle 710 and triggers the reading of the carrier identification through, for example, the reader antenna 731 (Fig. 8, Block 810). The antenna reads the identification of the carrier 720 from the RFID tag 721 and sends a signal regarding the tag identifier to the controller 760 (Fig. 8, Blocks 815, 820). The controller 760 may determine if the carrier 720 and its contents are in a desired location within the AMHS (e.g. verify the carrier that is being picked up is the carrier that is scheduled to be picked up by the vehicle at, for example, a predetermined time and location) based on the identification information read by the reader (Fig. 8, Block 825). For example, the material control system 770 of the controller 760 may look up, for example, the content of the carrier 720 corresponding to the identification information read by the reader in the association database. In alternate embodiments, the carrier and its contents can be verified in any suitable manner.

If the content of the carrier and/or identification information matches a predetermined identification information/carrier contents in, for example, the database for a predetermined processing operation (e.g. the carrier is the carrier scheduled to be picked up), the material control system 770 may cause the vehicle 710 to transport the carrier 720 to a predetermined location including, but not limited to, processing stations and storage areas (Fig. 8, Block 830). If the content of the carrier and/or the identification information does not match a predetermined identification information/carrier content the material control system 770 may provide an automatic recovery of the mislocated carrier/payload. For example, the material control system 770 may instruct the transport vehicle of the AMHS to transport the carrier 720 to any suitable area of the AMHS such as a reconfiguration station where the contents of the carrier 720 can be re-identified and/or re-associated with the carrier identifier. The reconfiguration station may be any suitable station. In one exemplary embodiment, the reconfiguration station may be a manually operated station where an operator inspects the contents of the carrier 720 and re-associates the content of the carrier 720 with the carrier identification. In another exemplary embodiment, the reconfiguration station may be an automated station where, for example, a robot inspects the contents of the carrier 720 with any suitable sensors and re-associates the contents with the carrier identification. In alternate embodiments the content of the carrier may be inspected/re-associated in any suitable manner. In still other exemplary embodiments any suitable operations for reintroducing the contents of the carrier back into the WIP may be conducted at the reconfiguration station. For example, if a mismatch is found the material control system 770 may treat the contents of the carrier 720 as a new lot with a new identifier, determine a desired destination of the carrier based on, for example, the carrier contents via real time dispatching, or duplicate the lot handling by reinserting the carrier 720 into the WIP at a predetermined location (Fig. 8, Blocks 835-845). In alternate embodiments, the mislocated carriers and their respective content or payload can be reintroduced into the WIP in any suitable manner such that they are inserted at a desired stage of processing.

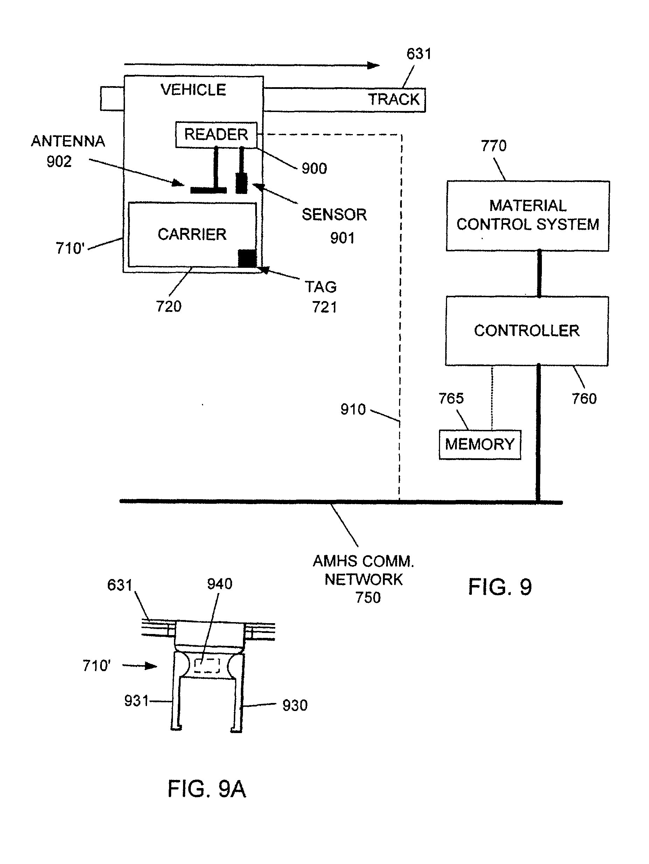

Referring now to Figure 9 an identification reader will be described in accordance with another exemplary embodiment. As can be seen in Figure 9, the identification reader 900 may be incorporated into the transport vehicle 710'. The transport vehicle 710' may be substantially similar to the transport vehicle 710 described above with respect to Figure 7. The identification reader 900 may also be substantially similar to the identification reader 730 described above with respect to Figure 7. For example, the identification reader may have an antenna 902 and a sensor 901 for sensing the carrier 720 and reading identification information from, for example the RFID tag 721 of the carrier 720. In this example, the components of the identification reader 900 may be positioned at any suitable location(s) in or around the transport vehicle such that identification information can be gathered when the carrier 720 is transported. For example, referring to Figure 9A, the transport vehicle may have arms 930, 931 for engaging or otherwise stabilizing the carrier 720 so that the carrier may be transported. In one exemplary embodiment the reader electronics 900, sensor 901 and/or antenna 902 may be built into or mounted on one or more of the arms 930, 931. In other exemplary embodiments, the sensor 901 and/or antenna 902 may be located in one or more of the arms 930, 931 while the sensor electronics 900 may be located with the transport vehicle electronics 940 such that the reader is incorporated into the transport vehicle electronics. In alternate embodiments, sensor electronics 900, antenna 902 and/or sensor 901 may be located separately or together at any suitable location(s). The sensor 900 may be suitably connected to the AMHS communication network 750 and the controller 760 in any suitable manner. For example, the sensor in this exemplary embodiment may be connected to the controller by any suitable wired or wireless communication link 910. For example, the communication link 910 may be an infrared, cellular, radio frequency, LAN, WAN or any other suitable short or long range communication link.

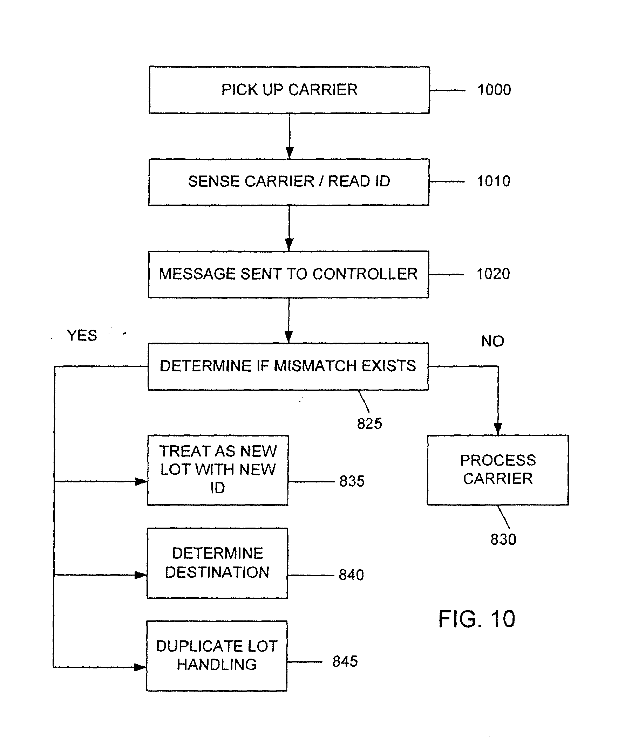

Referring now to Figure 10, an exemplary operation of the identification reader of Figure 9 will now be described. In this exemplary embodiment the transport vehicle 710' picks a carrier 720 from any suitable location such as, for example, processing station 403 (See Fig. 6) (Fig. 10, Block 1000). The carrier sensor 901 detects the carrier 720 and triggers the antenna 902 to read the identification information from the RFID tag 721 (Fig. 10, Block 1010). In alternate embodiments, the antenna 902 may be triggered to read the identification information in any suitable manner. For example, the reading of the identification information may be triggered when the arms 930, 931 of the vehicle 710' engage the carrier. The identification reader electronics 900 may send a signal corresponding to the identification information read from the carrier 720 to the controller 760 (Fig. 10, Block 1020) where the controller determines if a mismatch between the carrier 720 identification/contents and a predetermined carrier identification/content in a manner substantially similar to that described above with respect to Blocks 825-845 of Figure 8.

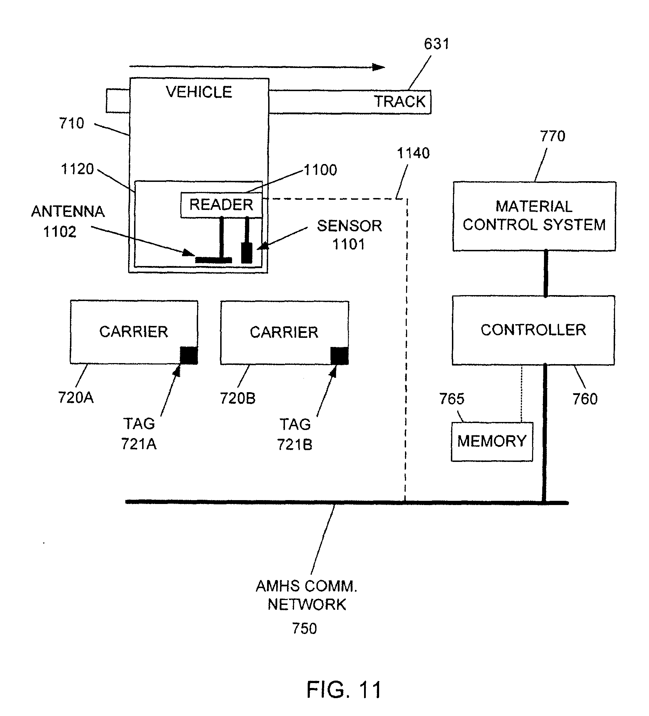

Referring now to Figure 11 another identification reader will be described in accordance with an exemplary embodiment. In this exemplary embodiment, the identification reader may be incorporated into a carrier that will be referred to herein as diagnostic carrier 1120 for exemplary purposes only. In this exemplary embodiment the reader 1100, antenna 1102 and reader sensor 1101 may be substantially similar to that described above with respect to Figure 7. The reader 100 may be suitably located within the carrier and positioned such that the RFID tags 721A, 721B of the carriers 720A, 720B may be read. In alternate embodiments any suitable device capable of reading the RFID tags 721A, 72 1 B may be inserted into the carrier 1120. The devices may include, but are not limited to, tablet personal computers and personal digital assistants. The devices may have any suitable sensors and antenna for detecting the presence of and reading the identification information from carriers 720A, 720B. The identification reader 1100 may be suitably connected to the controller through any suitable connection 1140 such as, for example, in a manner substantially similar to that described above with respect to Figure 9. In alternate embodiments, the carrier may have an interface or connector that engages a corresponding interface or connector of the transport vehicle 710 when the diagnostic carrier 1120 is picked. In this alternate embodiment communication with the controller 760 may be established through the interface between the vehicle 710 and diagnostic carrier 1120. In still other alternate embodiments, communication between the diagnostic carrier 1120 and the controller 760 may be established in any suitable manner.

In this exemplary embodiment, the diagnostic carrier 1120 may be stored in any suitable offline position when the WIP carriers, such as carrier 720A, 720B are not being scanned. In alternate embodiments, the diagnostic carrier may be stored in an online position. The storage position of the diagnostic carrier may be any suitable position that does not interfere with the flow of work through the processing facility. For example, the offline position may include, but is not limited to, a stocker, an under track storage location and a shunt or buffer of a track segment. In alternate embodiments the diagnostic carrier 1120 may be manually supplied to the vehicle 710 by an operator. In other alternate embodiments the diagnostic carrier 1120 may be supplied to the transport vehicle 710 from any suitable location and in any suitable manner. The WIP carriers 720A, 720B in this exemplary embodiment may also be stored in any suitable location such as for example, the under track storage 620, 621 shown in Figure 6. In alternate embodiments, the carrier to be identified may be located in, for example, a load port of a processing tool or at any other suitable location accessible by the transport vehicle 710.

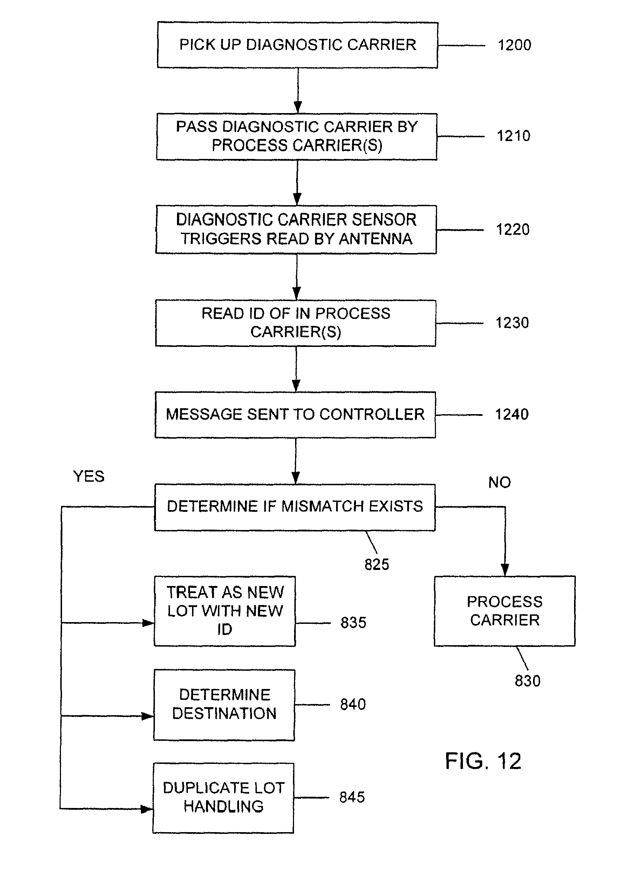

Referring now to Figure 12, the operation of the diagnostic carrier 1120 will now be described. The transport vehicle 710 picks the diagnostic carrier 1120 from any suitable position such as the offline position described above (Fig. 12, Block 1200). The diagnostic carrier may be transported through the manufacturing facility by the AMHS transport vehicle 710 such that the diagnostic carrier 1120 passes by any desired WIP carriers (Fig. 12, Block 1210) such as carriers 720A, 720B that may be, for example, located in the under track storage as described above with respect to Figure 6. In alternate embodiments the diagnostic carrier may be transported by any suitable WIP having an RFID tag that is accessible by the transport vehicle (e.g. within the detection range of the RFID reader 1100 of the diagnostic carrier 1120). In this exemplary embodiment, as the diagnostic carrier 1120 passes by, for example carrier 720A, the carrier sensor 1101 of the reader 1100 triggers the reading of the identification information of tag 721A by antenna 1102 of the reader 1100 (Fig. 12, Block 1220). As may be realized as the diagnostic carrier 1120 passes by each successive WIP carrier in, for example, the under track storage areas, the sensor 1101 triggers the reading of respective identification information. In alternate embodiments, the tag reader may interrogate the RFID tags 721A, 721B of the WIP carriers 720A, 720B in any suitable manner. For example, in one alternate embodiment the reader 1100 may be configured to continually output a signal for energizing RFID tags that the reader passes without the sensor 1101 triggering the interrogation. The reader 1100 of the diagnostic carrier 1120 reads the identification information of the WIP carriers as the diagnostic carrier 1200 passes by the respective WIP carriers (Fig. 12, Block 1230). The identification reader 1100 sends a signal to the controller 760 corresponding to the identification information read by the reader 1100 (Fig. 12, Block 1240) where, for example, the material control system 770 of the controller 760 determines if there is a mismatch between the locations (and/or payloads) of the WIP carriers scanned and a predetermined location of the respective carriers corresponding to the identification information scanned by the reader 1100 as described above with respect to Blocks 825-845 of Figure 8).

As may be realized, the location of a respective WIP carrier within the AMHS may be determined as each WIP carrier identification information is read by the reader 1100. For example, the position of the transport vehicle 710 carrying the diagnostic carrier 1120 may be recorded and correlated to the identification data of a respective one of the WIP carriers 720A, 720B as the diagnostic carrier 1120 passes by a respective one of the WIP carriers 720A, 720B. As may also be realized the controller 760 (and the material control system 770 of the controller 760), for example, may be configured to record the position of the transport vehicle in any suitable manner. For example, in one exemplary embodiment, the sensor 1101 of the reader 100 may trigger the controller 760 to record the position of the transport vehicle 710 as the sensor 1101 detects the WIP carrier. In other exemplary embodiments, the controller 760 may be configured to record the position of a respective WIP carrier when the identification reader 1100 sends a signal to the controller 760 corresponding to the identification information read by the reader 1100. The controller may be configured to compensate for any lag time in receiving the signal as opposed to the actual time the transport vehicle passes by the WIP carrier. For example, the controller may include suitable algorithms for determining the position of the transport vehicle using, for example, information pertaining to the speed of the vehicle and the time it takes for the information signal to reach the controller. In alternate embodiments, any lag time between when the information signal is received and when the position of the transport vehicle is recorded may be compensated for in any suitable manner. As described above, the material control system 770, for example, may determine if a mismatch exists between the identified WIP carrier and a predetermined position for each respective WIP carrier by merging the identification information with the recorded position of the transport vehicle for each respective WIP carrier.

As may be realized, in this exemplary embodiment, the diagnostic carrier 1120 may be scheduled to traverse one or more sections of the AMHS track at any suitable time. For example, the AMHS may be configured to pick the diagnostic carrier 1120 and transport it past any suitable WIP any suitable number of times each day (e.g. once a day, twice a day, three times a day, etc.). In other exemplary embodiments, the AMHS may be configured to allow the diagnostic carrier 1120 to be manually picked and transported throughout the AMHS any suitable times. In alternate embodiments, any suitable number of diagnostic carriers may be transported throughout the AMHS at any suitable times. In other exemplary embodiments, if there is a mismatch found as described herein, the diagnostic carrier 1120 may be transported by each of the WIP carriers in, for example, the track segment where the mismatch was found to verify the other WIP carriers are at their predetermined positions.

In another exemplary embodiment, the diagnostic carrier 1120 may also allow for the detection of lost payloads. If for example, a mismatch is found among the WIP carriers and it is determined that a WIP carrier is lost in the AMHS, the diagnostic carrier may be deployed automatically or manually to scan, for example, the under track storage areas such as areas 620, 621 to find the lost payload. In alternate embodiments, the diagnostic carrier 1120 may scan any suitable storage locations, including but not limited to, under track storage, load ports or any other suitable area accessible to the AMHS to allow for the identification of lost payloads.

The AMHS described above having the ability to identify the material or payloads within or handled by the AMHS allows for the identification of mislocated carriers/payloads to be identified in a quick and efficient manner which may result in the prevention of lost payloads. As described above, the identification reading capability can be incorporated into any suitable area of the AMHS including, but not limited to, the transport vehicle, positioned so the transport vehicle can drive by the reader, as a payload within a carrier or otherwise incorporated into a carrier that can be transported by the transport vehicles of the AMHS. In addition diagnostic carriers can be transported throughout the AMHS in the event of a lost payload to efficiently identify the lost payload. The material control system of the controller may be configured to automatically return the mislocated carriers/payloads to a predetermined position for reinsertion into the WIP. As may be realized the reinsertion of the lost payloads/carriers may also be performed manually through the material control system.

As may also be realized, the identification of substrate cassettes during transport in the AMHS and/or while the substrate cassettes are in, for example, an under track storage area allows for reduced production times as the processing tools can process the substrates without reading an identification of a carrier interfaced with the tool, removing the carrier if the carrier is identified as the incorrect carrier and obtaining the correct carrier from somewhere within the AMHS.

It should be understood that the exemplary embodiments described herein may be employed individually or in any combination thereof. It should also be understood that the foregoing description is only illustrative of the exemplary embodiments. Various alternatives and modifications can be devised by those skilled in the art without departing from the exemplary embodiments. Accordingly, the exemplary embodiments are intended to embrace all such alternatives, modifications and variances that fall within the scope of the appended claims.

## Claims

1. A material handling system comprising:
a controller;
a transport system, the transport system comprising transport track sections and at least one transport vehicle, the at least one transport vehicle configured to move along the transport track sections and configured to transport a carrier; and
at least one identification tag reader located along a particular transport track section, the at least one identification tag reader being configured to read an identification tag of the carrier being transported by the at least one transport vehicle and being further configured to send a information signal to the controller;
wherein the controller is configured to verify at least a location of the carrier based on the information signal.

2. The material handling system of claim 1, wherein the transport track sections comprise turntables joining different transport track sections and the at least one identification tag reader is located substantially in or on the turntables.

3. The material handling system of claim 1, wherein the at least one identification tag reader is located substantially at an end of the particular transport track section.

4. The material handling system of claim 1, wherein the at least one identification tag reader is configured to read the identification tag as the carrier is being transported from a substrate processing station.

5. The material handling system of claim 1, wherein the material handling system comprises an automated overhead material handling system.

6. The material handling system of claim 1, wherein the controller is configured to effect a recovery of a mislocated carrier when a detected position of the mislocated carrier does not match a predetermined position.

7. The material handling system of claim 1, wherein the identification tag comprises a radio frequency identification tag.

8. A material handling system comprising:
a controller;
a transport system, the transport system comprising transport track sections and at least one transport vehicle, the at least one transport vehicle being configured to move along the transport track sections and configured to transport a carrier; and
an identification tag reader in communication with the controller and being configured to traverse the transport track sections as a unit with the at least one transport vehicle, wherein the identification tag reader is configured to read an identification tag of the carrier being transported by the at least one transport vehicle and to send a information signal to the controller;
wherein the controller is configured to verify at least a location of the carrier based on the information signal.

9. The material handling system of claim 8, wherein the identification tag reader is located substantially in or on a particular transport vehicle.

10. The material handling system of claim 8, wherein the identification tag reader is configured to read the identification tag as a respective carrier is being transported from a substrate processing station.

11. The material handling system of claim 8, wherein the material handling system comprises an automated overhead material handling system.

12. The material handling system of claim 8, wherein the controller is configured to effect a recovery of a mislocated carrier when a detected position of the mislocated carrier does not match a predetermined position.

13. A method of verifying a location of a carrier payload in a material handling system, the method comprising:
transporting a carrier on a transport vehicle of the material handling system;
reading an identification tag of the carrier being transported by the transport vehicle; and
verifying a payload of the carrier is at a predetermined position, wherein the verifying is based on reading the identification tag.

14. The method of claim 13, wherein an identification tag reader for reading the identification tag is located along a track segment of the material handling system.

15. The method of claim 13, wherein an identification tag reader for reading the identification tag is located substantially in or on a turntable connecting different sections of track of the material handling system.

16. The method of claim 13, wherein an identification tag reader for reading the identification tag is configured to traverse a track of the material handling system with the transport vehicle.

17. The method of claim 13, wherein the identification tag of the carrier is configured to be read in a track segment of the material handling system.

18. The method of claim 13, wherein the identification tag is configured to be read as a carrier is being transported from a substrate processing station.

19. The method of claim 13, further comprising recovering a mislocated payload when a detected position of the mislocated payload does not match a predetermined position.
